# FASCICULE DE BREVET EUROPEEN

(11) **EP 0 883 171 B1**
(45) Date de publication et mention de la délivrance du brevet: **17.03.2010**
(21) Numéro de dépôt: 98401318.5
(22) Date de dépôt: 02.06.1998
(51) Int. Cl.: H01L 21/56

(54) **Procédé de fabrication de boîtiers semi-conducteurs comprenant un circuit intégré**
Herstellungsverfahren für ein Halbleitergehäuse mit einer integrierten Schaltung
Semiconductor package manufacturing method having an integrated circuit

(30) Priorité: 03.06.1997 FR 9706808
(43) Date de publication de la demande: 09.12.1998
(73) Titulaire: STMicroelectronics S.A., 92120 Montrouge (FR)
(72) Inventeur: Exposito, Juan, 38330 St. Nazaire les Eymes (FR); Herard, Laurent, 38000 Grenoble (FR); Cigada, Andrea, 20155 Milan (IT)
(74) Mandataire: Casalonga, Axel

(56) Documents cités:
- EP-A- 0 751 561
- DE-A- 3 619 636
- PATENT ABSTRACTS OF JAPAN vol. 097, no. 006, 30 juin 1997 -& JP 09 036151 A (JAPAN AVIATION ELECTRON IND LTD), 7 février 1997
- PATENT ABSTRACTS OF JAPAN vol. 097, no. 007, 31 juillet 1997 -& JP 09 082741 A (SEIKO EPSON CORP), 28 mars 1997

## Description

La présente invention concerne un procédé de fabrication de boîtiers semi-conducteurs comprenant respectivement un substrat, une pastille formant un circuit intégré et fixé sur une zone du substrat, des moyens de connexion électrique reliant la pastille à des zones de connexion électrique extérieure situées sur une face du substrat, ainsi qu'un enrobage d'encapsulisation en résine.

En principe et de façon habituelle, les zones de connexion électrique extérieure et la pastille sont disposées de part et d'autre du substrat et l'enrobage enveloppe, d'un côté du substrat, la pastille et les moyens de connexion électrique.

Dans la technique de fabrication actuellement utilisée, on réalise individuellement l'enrobage de chacune des pastilles fixées et connectées sur une plaque de substrat en disposant cette plaque dans un moule qui présente autant de cavités individuelles que de pastilles. Puis on coupe le substrat entre chaque enrobage. Cette solution nécessite la fabrication, l'utilisation et le stockage d'autant de moules différents d'injection d'enrobage que l'on a de boîtiers différents présentant des dimensions de pastilles différentes et des dispositions différentes de ces pastilles sur une plaque de substrat. De même, il faut disposer d'un outil de découpe particulier attribué à chaque dimension de pastille et à chaque dimension de plaque de substrat.

Le but de la présente invention est de proposer un procédé de fabrication de boîtiers semi-conducteurs susceptibles de permettre des économies de fabrication et d'obtenir une plus grande flexibilité de production.

Le procédé selon l'invention est destiné à la fabrication de boitiers semi-conducteurs comprenant respectivement un substrat, une pastille formant un circuit intégré et fixée sur une zone du substrat, des moyens de connexion électrique reliant la pastille à un groupe de zones de connexion électrique extérieure situées sur une face du substrat, ainsi qu'un enrobage d'encapsulisation.

Selon l'invention, le procédé consiste à réaliser de façon matricielle une multiplicité de groupes de zones de connexion sur une plaque commune de substrat, correspondant à autant de zones de fixation de pastilles, à fixer une pastille sur chaque zone de fixation de la plaque commune de substrat, à relier électriquement chaque pastille aux zones de connexion électrique associées, de façon à obtenir un assemblage plaque de substrat-pastilles connectés. Selon l'invention, le procédé consiste, dans une seconde étape, à disposer cet assemblage dans un moule et à injecter une matière d'enrobage dans le moule de façon à obtenir, en une seule opération de moulage, un bloc parallélépipédique, et, dans une étape ultérieure, à découper ledit bloc parallélépipédique au travers de son épaisseur en unités constituant chacune un boîtier semi-conducteur.

Selon l'invention, le procédé consiste à réaliser la découpe du bloc parallélépipédique par sciage.

Selon l'invention, le procédé consiste aussi à coller le bloc parallélépipédique sur une bande autocollante pelable et à réaliser l'opération de sciage en engageant la scie au travers du bloc au-delà de sa face collée sur cette bande.

Selon l'invention, le procédé consiste à coller la face du bloc parallélépipédique exempte de zones de connexion sur la bande autocollante.

Selon l'invention, le procédé consiste à déposer des billes ou boules en matériau de soudage sur les zones de connexion.

La présente invention sera mieux comprise à l'étude d'un procédé de fabrication de boîtiers semi-conducteurs décrit à titre d'exemple non limitatif et illustré par le dessin sur lequel :
- la figure 1 représente schématiquement une coupe transversale d'un boîtier semi-conducteur obtenu par le procédé selon l'invention ;
- la figure 2 représente une vue frontale dudit boîtier ;
- la figure 3 montre schématiquement une première étape du procédé selon l'inveniton et représente en coupe transversale une plaque de substrat munie de pastilles ;
- la figure 4 représente une vue frontale de la face de ladite plaque de substrat apposée aux pastilles ,
- la figure 5 montre schématiquement une étape suivante du procédé selon l'invention et représente ladite plaque de substrat munie de pastilles connectées électriquement par des fils ;
- la figure 6 montre schématiquement une étape suivante de l'invention consistant en l'encapsulisation dans un moule représenté en coupe desdites pastilles et desdits fils ;

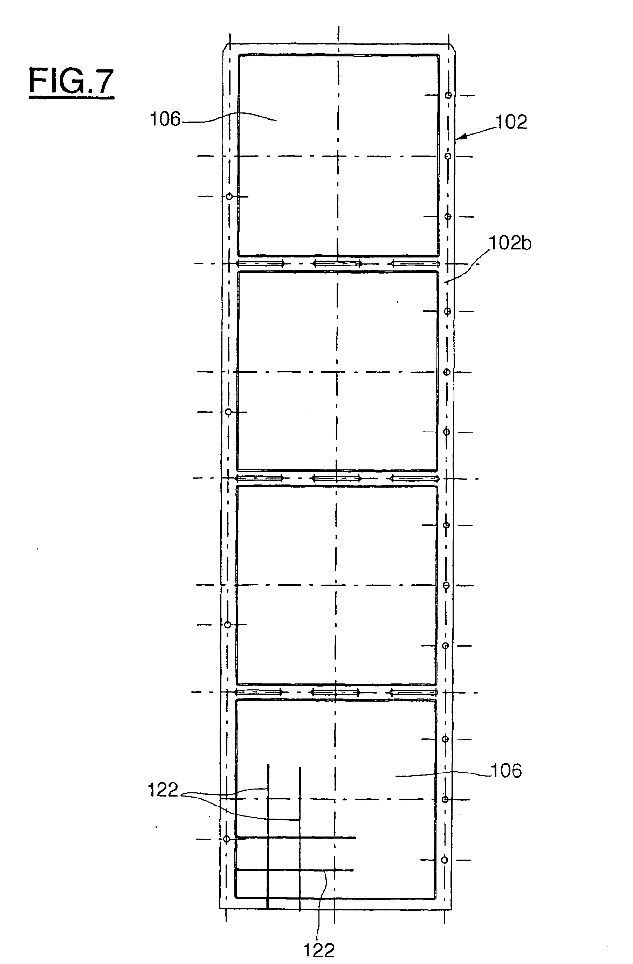

- la figure 7 représente une vue arrière du bloc sortant dudit moule ;
- la figure 8 montre schématiquement une étape suivante du procédé selon l'invention et représente une coupe transversale dudit bloc ;
- et la figure 9 montre schématiquement une étape suivante du procédé selon l'invention et représente une coupe transversale dudit bloc lors d'une opération de sciage de ce bloc.

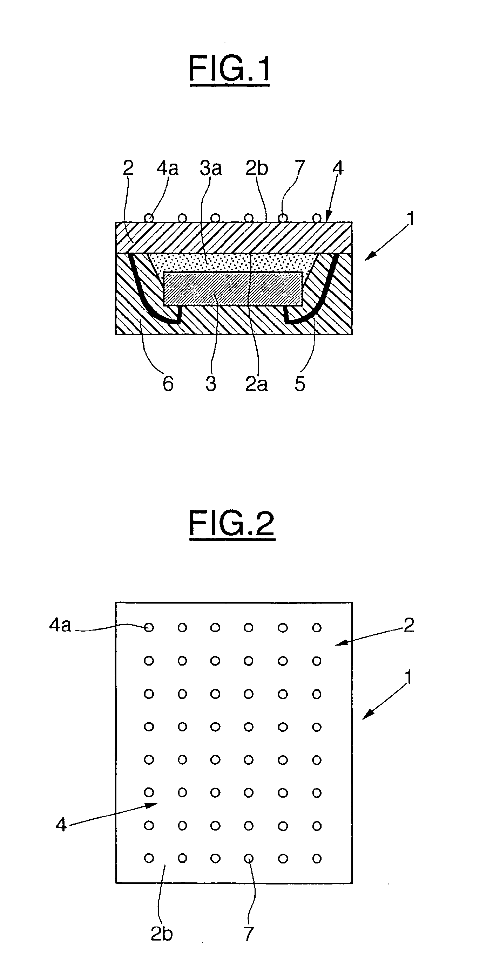

En se reportant aux figures 1 et 2, on voit qu'un boîtier semi-conducteur parallélépipédique, repéré d'une manière générale par la référence 1, obtenu par le procédé de fabrication qui va maintenant être décrit, comprend un substrat plat 2 par exemple de contour carré, une pastille 3 fixée à une face 2a du substrat 2 grâce à une couche mince de colle 3a, une multiplicité de zones 4 de connexion électrique extérieures réparties sur la face 2b du substrat 2 opposée à sa face 2a, des moyens de connexion électrique reliant sélectivement la pastille 3 et les zones de connexion électrique 4 et comprenant des fils de connexion électrique 5 aboutissant au substrat 2 et des connexions internes à ce substrat non représentées, ainsi qu'un enrobage en résine 6 d'encapsulisation de la pastille 3 et des fils de connexion 5, cet enrobage 6 étant situé du côté de la face 2a du substrat 2. En outre, le boîtier semi-conducteur 1 est muni de gouttes ou boules de connexion 7 sur chacune des zones de connexion électrique 4, en vue de la soudure et de la connexion électrique du boîtier semi-conducteur 1 par exemple aux pistes d'une plaque de circuit imprimé.

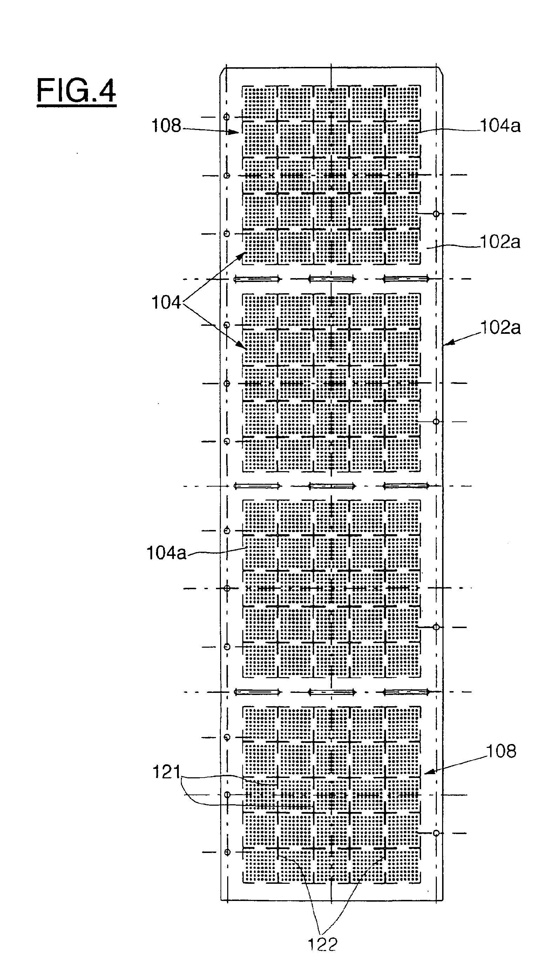

En se reportant à la figure 4, on voit que le procédé de fabrication décrit consiste à réaliser, sur une face 102a d'une plaque commune de substrat 102 rectangulaire, une multiplicité de groupes 104 de zones de connexion électrique 104a et de moyens de connexion électrique traversant la plaque commune de substrats 102 et reliés aux zones 104a.

Dans l'exemple représenté, les groupes 104 sont disposés sous une présentation en forme de matrice sur la face 102a et sont au nombre de cinq dans le sens de la largeur de la plaque commune de substrat 102 et au nombre de vingt dans le sens de sa longueur, l'espace séparant les groupes des cinquième et sixième rangées, dixième et onzième rangées et quinzième et seizième rangées dans le sens de la longueur de la plaque commune de substrat 102 étant plus large de manière à former quatre ensembles 108 de vingt cinq groupes 104 espacés de la longueur de la plaque commune de substrat 102.

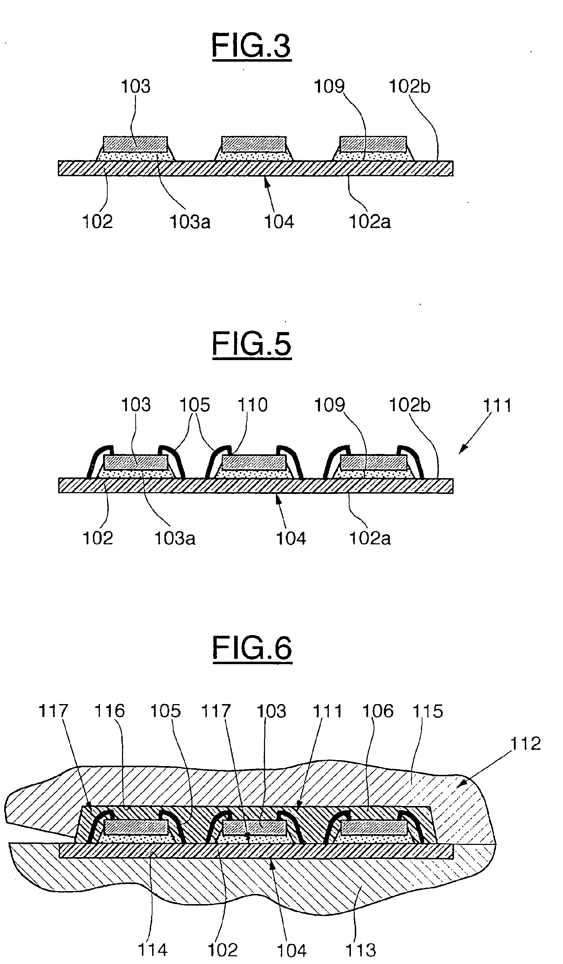

En se reportant à la figure 3, on voit que l'étape suivante du procédé de fabrication décrit consiste à fixer une multiplicité de pastilles 103 respectivement sur des zones de fixation 109 de la face 102b de la plaque commune de substrat 102 opposée à sa face 102a, à l'aide de minces couches de colle 103a. Les pastilles 103 se trouvent alors disposées sous une présentation en forme de matrice correspondant au travers de la plaque commune de substrat 102 aux groupes 104 de zones de connexion électrique 104a.

En se reportant à la figure 5, on voit que l'étape suivante du procédé de fabrication décrit consiste à relier sélectivement les plots de connexion 110 des pastilles 103 aux moyens de connexion de la plaque commune de substrat 102 en leur connectant les extrémités de fils de connexion électrique 105 qui se trouvent alors en l'air, de façon à relier les plots de chaque pastille 103 sélectivement aux zones de connexion électrique 104 des groupes 104 qui leur sont respectivement associées. On obtient alors un assemblage connecté repéré d'une manière générale par la référence 111, comprenant la plaque commune de substrat 102 et les pastilles 103 connectées comme décrit ci-dessus.

Comme le montre la figure 6, l'étape suivante du procédé de fabrication décrit consiste à disposer l'assemblage 111 à l'intérieur d'un moule d'injection 112 comprenant une partie 113 qui présente une cavité 114 recevant dans son épaisseur la plaque commune de substrat 102 et une partie 115 qui présente quatre cavités 116 dans lesquelles s'étendent respectivement, à distance de ses parois, les pastilles 103 et les fils de connexion 105 correspondant des ensembles 108.

Cette étape consiste ensuite à injecter à l'intérieur de la cavité 116 une résine d'encapsulisation des pastilles 103 et des fils de connexion 105 de façon à obtenir en une seule opération de moulage quatre enrobagse 106 contre la face 102a de la plaque de substrat 102. On obtient alors un bloc sensiblement parallélépipédique repéré d'une manière générale par la référence 117, à multipastilles 103 associées dans les enrobages 106 à la plaque commune de substrat 102.

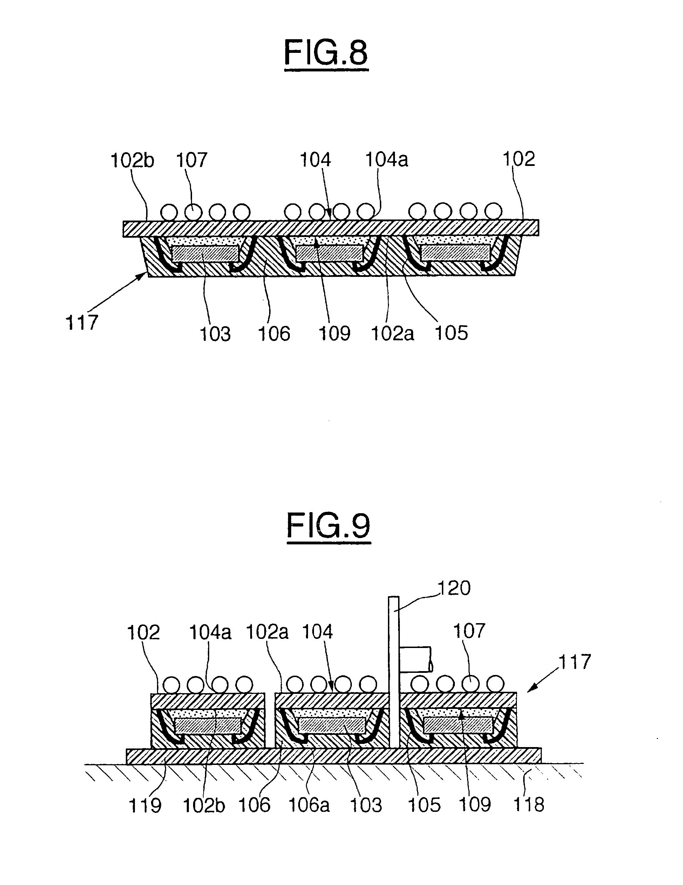

En se reportant à la figure 8, on voit que dans une étape ultérieure le procédé de fabrication décrit peut consister à déposer une goutte ou boule de connexion 107 sur chaque zone de connexion 104 de la face 102a de la plaque de substrat 102.

En se reportant à la figure 9, on voit que l'étape suivante du procédé de fabrication décrit consiste à fixer la face 106a de l'enrobage 106 du bloc parallélépipédique 107, opposée à la face 102a de la plaque commune de substrat 102 incluse dans ce bloc, sur un support plan 118 par l'intermédiaire d'une bande pelable 119 à deux faces autocollantes.

Puis, le procédé de fabrication décrit consiste à couper longitudinalement et transversalement le bloc parallélipipédique 107, dans le sens de son épaisseur, à l'aide d'une scie 120, le long des lignes de séparation longitudinales et transversales 121 et 122 s'étendant entre lesdits différents groupes 104 de zones de connexion électrique 104a auxquelles sont respectivement associées les pastilles 103. Au cours de cette opération, la scie 120 est engagée au travers du bloc parallélipipédique 107 au-delà de sa face 106a collée sur la bande 119 de manière à effectuer l'opération de découpe complètement.

Lorsque l'opération de découpe par sciage ci-dessus est effectuée, on peut alors décoller de la bande 119 les différents morceaux du bloc paralllépipédique 117, chacun de ces morceaux correspondant à un boîtier semi-conducteur 1 tel que décrit précédemment en référence aux figures 1 et 2.

Le procédé de fabrication qui vient d'être décrit présente l'avantage de pouvoir fabriquer dans un même moule adapté pour recevoir une plaque commune de substrat 102 déterminée, des boîtiers semi-conducteurs 1 de dimensions différentes.

En effet, sur différentes plaques communes de substrat 102, on peut prévoir des nombres différents de groupes 104 de zones de connexion électrique 104a couvrant des surfaces différents, adaptées en correspondance aux dimensions des pastilles 103 associées, en les disposant comme dans l'exemple décrit précédemment, selon des matrices adaptées aux surfaces que lesdits groupes de zones de connexion et lesdites pastilles occupent.

Il conviendra alors d'adapter uniquement les distances entre les différentes lignes 121 et 122 de découpe aux surfaces afin d'obtenir des boîtiers semi-conducteurs dont le pourtour présente des dimensions souhaitées.

## Revendications

1. Procédé de fabrication de boîtiers semi-conducteurs (1) comprenant respectivement un substrat, une pastille formant un circuit intégré et fixée sur une zone du substrat, des moyens de connexion électrique reliant la pastille à un groupe de zones de connexion électrique extérieure situées sur une face du substrat, ainsi qu'un enrobage d'encapsulation, comprenant les étapes suivantes :
- réaliser de façon matricielle une multiplicité de groupes (104) de zones de connexion (104a) sur une plaque commune de substrat (102), correspondant à autant de zones (109) de fixation de pastilles,
- fixer une pastille (103) sur chaque zone (109) de fixation de la plaque commune de substrat,
- relier électriquement chaque pastille (103) aux zones (104a) de connexion électrique associées utilisant des moyens de connexion électrique (105), de façon à obtenir un assemblage (111) plaque de substrat-pastilles connectés,
- disposer cet assemblage (111) dans un moule (112) et à injecter une matière d'enrobage (106) dans le moule de façon à obtenir, en une seule opération de moulage, un bloc parallélépipédique (117) présentant d'un côté ledit substrat, le moule comprenant une cavité (114) recevant dans son épaisseur ladite plaque et une cavité (116) recevant à distance de ses parois lesdites pastilles et les moyens de connexion électrique.
- déposer des billes ou boules (107) en matériau de soudage sur les zones de connexion (104a) du substrat (102) opposées à la matière d'enrobage moulée (106),
- coller la face (106a) dudit bloc parallélépipédique (117) exempte de zones de connexion et opposée auxdites billes de connexion (107) sur un support (118) par l'intermédiaire d'une bande autocollante pelable (119)
- et découper par sciage ledit bloc parallélépipédique (117) au travers de l'épaisseur dudit substrat (102) et de la matière d'enrobage (106) en engageant la scie (120) au travers du bloc (117) au-del à de sa face collée sur ladite bande (119), de façon à obtenir des unités constituant chacune un boîtier semi-conducteur (1).

## Claims

1. Process for manufacturing semiconductor packages (1) comprising, respectively, a substrate, a chip which forms an integrated circuit and is attached to one region of the substrate, electrical connection means connecting the chip to a group of external electrical connection regions lying on one face of the substrate, as well as an encapsulating encasement, comprising the following steps:
- producing, in a matrix configuration, a multiplicity of groups (104) of connection regions (104a) on a common substrate plate (102), corresponding to as many chip attachment regions (109);
- attaching a chip (103) to each attachment region (109) of the common substrate plate;
- electrically connecting each chip (103) to the associated electrical connection regions (104a) by using electrical connection means (105), so as to obtain an assembly (111) consisting of the substrate plate and the connected chips;
- placing this assembly (111) in a mould (112) and injecting an encasement material (106) into the mould so as to obtain, in a single moulding operation, a parallelepipedal block (117) having, on one side, said substrate, the mould comprising a cavity (114) in its thickness that receives said plate and a cavity (116) that receives, at some distance from its walls, said chips and the electrical connection means;
- depositing balls or beads (107) of soldering material on the connection regions (104a) of the substrate (102) that are on the opposite side from the moulded encasement material (106);
- adhesively bonding the face (106a) of said parallelepipedal block (117) free of connection regions and on the opposite side from said connection balls (107) onto a support (118) by means of a peelable self-adhesive strip (119); and
- cutting, by sawing, said parallelepipedal block (117) through the thickness of said substrate (102) and through the encasement material (106), by engaging the saw (120) through the block (117) beyond its face bonded to said strip (119) so as to obtain units each constituting a semiconductor package (1).

## Patentansprüche

1. Verfahren zum Herstellen von Halbleitergehäusen (1), die jeweils ein Substrat, einen Chip, der eine integrierte Schaltung bildet und auf einer Zone des Substrats befestigt ist, elektrische Verbindungsmittel, die den Chip mit einer Gruppe von Zonen für die externe elektrische Verbindung, die sich auf einer Fläche des Substrats befinden, verbinden, und eine Einkapselungsummantelung enthalten, mit den folgenden Schritten:
- matrixartiges Herstellen mehrerer Gruppen (104) von Verbindungszonen (104a) auf einer gemeinsamen Platte des Substrats (102), die ebenso vielen Zonen (109) für die Befestigung von Chips entsprechen,
- Befestigung eines Chips (103) auf jeder Befestigungszone (109) der gemeinsamen Platte des Substrats,
- elektrisches Verbinden jedes Chips (103) mit den zugeordneten Zonen (104a) für die elektrische Verbindung unter Verwendung der elektrischen Verbindungsmittel (105), derart, dass eine Anordnung (111) aus Substratsplatte und verbundenen Chips erhalten wird,
- Anordnen dieser Anordnung (111) in einer Gießform (112) und Einspritzen eines Ummantelungsmaterials (106) in die Gießform, um in einem einzigen Gießvorgang einen parallelepipedischen Block (117) zu erhalten, der auf einer Seite das Substrat aufweist, wobei die Gießform einen Hohlraum (114), der in seiner Dicke die Platte aufnimmt, und einen Hohlraum (116), der in einem Abstand von seinen Wänden die Chips und die elektrischen Verbindungsmittel aufnimmt, enthält,
- Aufbringen von Kügelchen oder Kugeln (107) aus Schweißmaterial auf die Verbindungszonen (104a) des Substrats (102) gegenüber dem gegossenen Ummantelungsmaterial (106),
- Kleben der Fläche (106a) des parallelepipedischen Blocks (117) mit Ausnahme der Verbindungszonen und gegenüber den Verbindungskügelchen (107) mittels eines abziehbaren Selbstklebebandes (119) an einen Träger (118),
- und Schneiden durch Sägen des parallelepipedischen Blocks (117) in der Dicke des Substrats (102) und des Ummantelungsmaterials (106) durch Bringen der Säge (120) in Eingriff durch den Block (117) über eine an das Band (119) geklebte Fläche hinaus, derart, dass Einheiten erhalten werden, die jeweils ein Halbleitergehäuse (1) bilden.
